(19) **Europäisches Patentamt / European Patent Office / Office européen des brevets**

(11) **EP 1 041 869 B1**

(12) **EUROPEAN PATENT SPECIFICATION**

(45) Date of publication and mention
of the grant of the patent:
**15.04.2009  Bulletin 2009/16**

(51) Int Cl.:
*H05K 9/00* *(2006.01)*    *C08G 77/38* *(2006.01)*

(21) Application number: **00113095.4**

(22) Date of filing: **19.01.1996**

(54) **Form-in-place EMI gaskets**

In Situ gebildete elektromagnetisch abschirmende Dichtungen

Joints de blindage électromagnétique formés sur place

(84) Designated Contracting States:
**DE DK ES GB SE**

(30) Priority: **20.01.1995  US 375853**
**24.01.1995  US 377412**

(43) Date of publication of application:
**04.10.2000  Bulletin 2000/40**

(62) Document number(s) of the earlier application(s) in
accordance with Art. 76 EPC:
**96903530.2 / 0 804 868**

(73) Proprietor: **PARKER HANNIFIN CORPORATION**
**Cleveland**
**Ohio 44112 (US)**

(72) Inventors:
 • **Bunyan, Michael H.**
**Chelmsford, MA 01824 (US)**

 • **Kalinoski, John P.**
**Chelmsford, MA 01824 (US)**
 • **Lucia, Russell T.**
**Stoneham, MA 02180 (US)**
 • **Vilandre, Paul R.**
**Salem, NH 03079 (US)**
 • **Watchko, George R.**
**Stoneham, MA 02180 (US)**
 • **Shvartsman, Rudolf I.**
**Ballston Lake, NY 12019 (US)**
 • **Soron, John E.**
**Niskayuna, NY 12309-2507 (US)**

(74) Representative: **HOFFMANN EITLE**
**Patent- und Rechtsanwälte**
**Arabellastrasse 4**
**81925 München (DE)**

(56) References cited:
**EP-A- 0 368 612        GB-A- 802 358**
**GB-A- 2 115 084        US-A- 5 366 664**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

<u>Field of the Invention</u>

The present invention relates to electrically-conductive polymeric compositions, and more particularly to form-in-place EMI shielding gaskets and methods for forming such gaskets.

<u>Background of the Invention</u>

US-A-5 366 664 discloses a EMI shielding material comprising a hardenable, fluent polymeric thermal addition cure system; an electrically-conductive filler; and a catalyst having catalytic action that in the presence of heat catalyzes a reaction in the polymeric thermal addition cure system that causes the system to cure and harden.

EMI shielding gaskets (EMI gaskets) are used on several types of electronic equipment to provide protection against interference from electromagnetic energy, including radio frequency interference (RFI) and more broadly all bands of interference commonly called electromagnetic interference (EMI). A shielding gasket includes an electrically conductive element, be it a wire mesh, conductive filler or conductive plating, coating or fabric which prevents external EMI from interfering with an electronic device and/or protects other adjacent electronic devices from EMI emitted by an electronic device.

Typically, EMI gaskets are prepared in one of three configurations: linear, die cut or molded. By linear, it is meant as an extrusion, molding, etc. of a defined, straight length. By die cut, it is meant that a gasket configuration is formed from an electrically conductive elastomer sheet material which is cut by a die to the desired shape, such as round, square, etc. By molded, it is meant that the gasket configuration is formed by placing uncured elastomer which may contain conductive filler or a conductive mesh, into a specifically designed mold which then is subjected to compression (pressure) and then cured to cause the elastomer to assume the desired gasket configuration.

All three methods have disadvantages especially when used to form complex multidirectional or multiaxial gaskets, such as may occur in devices with a number of compartments that each need to be shielded, from each other as well as the external environment. Moreover, the problems are even more critical on smaller devices, such as cellular phones, notebook computers and other hand held devices, where the diameter of the gasket becomes very small and the ability to manufacture and attach such gaskets securely becomes very difficult and labor intensive.

Using linear gasketing material to form complex multiaxis/multidirectional gaskets (e.g. either x and y or in the x, y and z planes), is difficult, time consuming and costly. Each gasket portion must be hand cut and bonded to the adjacent portions of other linear gaskets and then bonded or secured in position upon the substrate.

Die cutting of conductive sheet stock will work in many instances especially in two plane (e.g. flat; x,y) applications, provided that each portion of the gasket is wide enough and/or thick enough to be self supportive. Die cutting parts however results in significant waste of the sheet stock because the material is typically a cross-linked resin such as silicone or polyurethane. This is not acceptable as it drives up the cost of such parts unacceptably. Further as die cutting is a rough process, the sheet stock needs to be fairly stiff and self supportive which is opposite that desired by the gasket user (i.e. soft and flexible).

Molding is slow and again generates scrap in the form of flash which must be removed. Furthermore, each gasket design must use a specifically designed mold, making the process expensive for all but large volume stock items.

<u>Summary of the Invention</u>

It an object of the present invention to provide a method of making a form-in-place EMI gasket, a system for forming complex multiaxis/multidirectional EMI gaskets in place with a minimum of generated scrap, and a form-in-place EMI gasket.

It is another object of the invention to provide means and methods for accurately and rapidly depositing a bead of material on a substrate, which method can eliminate or control drool formation.

Still another object of this invention is to provide apparatus for enabling extrusion of an EMI gasket material to form a gasket, which apparatus comprises gas pressure control means for controlling the rate of extrusion through an extrusion head or orifice to the atmosphere.

The invention provides an EMI shielding material according to claim 1 and a method of making same according to claim 13. Preferred embodiments of the invention are indicated in the dependent claims.

The present invention relates to an EMI shielding material that can be used to form a form-in-place EMI gasket, and a system for forming such a gasket using a table and/or dispenser capable of moving in multiaxial directions relative to each other and a substrate to be gasketed. The invention also relates to a process of providing a conductive elastomer, forming it in place along a desired gasket configuration so as to create a form-in-place EMI gasket.

The invention provides, according to one embodiment, a process for forming an EMI shielding gasket. The gasket can be a heat-cured gasket. The process comprises the steps of placing a fluent electrically conductive polymeric material in an extruder chamber, applying positive and negative air pressure to the chamber to control the extrusion of the material from the chamber of a bead of the material, the material forming an individual EMI gasket having desired cross-sectional areas, the bead is then cured, for example by heating, to form the final EMI gasket.

The invention provides, according to another embodiment, apparatus for extruding electrically conductive polymeric material. The apparatus includes a chamber having a first and second end for holding fluent polymeric material, an extrusion head attached to the first end for extruding the fluent polymeric material through an extrusion orifice. The apparatus includes a source of positive gas pressure and a source of negative gas pressure connected to a control module. The control module has an outlet for selectively applying the positive and negative pressure to the chamber. A conduit which connects the outlet of the control module with the second end of the extruder chamber provides a selected amount of pressure to the second end of the extrusion head. The air pressure supplied to the extruder can be varied and is adjusted depending on the speed of the extrusion head, the amount of EMI shielding material in the extruder chamber the flow rate characteristics of the material, and the viscosity of the EMI shielding material. The bead formation can be precisely controlled by varying the air pressure very rapidly. To terminate the bead formation, the pressure on the fluent polymeric material is rapidly reduced by connecting the conduit to negative gauge pressure. Once the bead has been formed on the substrate, the electrically conductive material is subjected to a curing process to cure the EMI shielding material.

According to another embodiment the invention provides EMI shielding material defined in part by a polymeric thermal addition cure system including an electrically-conductive filler. According to this and other embodiments, the polymeric system can include an elastomer base. The material desirably has bulk resistivity of less that about 0.050 ohm cm, and is readily extrudable. Upon exposure to a temperature of at least 85°C for a period of time of at least 30 minutes the material becomes essentially thermoset. The polymeric thermal addition cure system is defined, according to one aspect, by a first species having a first functional group, a second species having a second functional group that is reactive with the first functional group in the presence of a catalyst and heat, and a catalyst having catalytic action that in the presence of heat catalyzes a reaction between the first and second functional groups.

According to the invention the electrically-conductive filler adversely affects the catalytic activity of the catalyst, yet the catalyst is present in an amount sufficient to retain desired catalytic activity. Methods and arrangements for retaining the catalyst in an amount sufficient to retain catalytic activity are provided, and according to one the shielding material is packaged as a kit. The kit includes a first container containing a first pre-mixed component including the first species, the electrically-conductive filler, and the catalyst, a second container containing a second pre-mixed component including the first species, the second species, and the electrically-conductive filler. The kit includes as well a third container containing the catalyst. By this arrangement, the third container is used to replenish catalyst that is inhibited by the electrically-conductive filler. By "inhibited" is meant chemically or physically affected in a way that catalytic activity is reduced.

According to one embodiment of the invention an EMI shielding material includes a siloxane polymer including vinyl functional groups, a siloxane cross-linker including reactive hydrides, a silver-containing electrically-conductive filler, and a platinum catalyst. The silver-containing electrically-conductive filler inhibits the platinum catalyst, thus methods and arrangements of the invention provide for replenishment of the catalyst to insure that sufficient catalytic action can be provided.

According to another embodiment of the invention a method of making an EMI shielding gasket is described. The method includes extruding onto a substrate a free-form polymeric thermal addition cure system, which includes an electrically-conductive filler and which preferably has a viscosity of from about 100 to about 10,000 Pa·s (about 100,000 to about 10,000,000 centipoise), more preferably from about 1,000 to about 4000 Pa·s about 1,000,000 to about 4,000,000 centipoise). The system then is heated at a temperature and for a period of time sufficient to cure the system, thereby forming a gasket having bulk resistivity of less that about 0.050 ohm cm. The gasket can be formed without applying pressure, for example with a mold, to the to the extrudate. Prior to the extruding step, according to one aspect, the polymeric thermal addition cure system is prepared by forming a mixture of a first species having a first functional group, a second species having a second functional group that is reactive with the first functional group in the presence of a catalyst and heat, a catalyst that catalyzes a reaction between the first and second functional groups, and the electrically-conductive filler.

According to one aspect of the method, the polymeric addition cure system is prepared by mixing together a first pre-mixed component and a second pre-mixed component. The first pre-mixed component includes the first species, the electrically-conductive filler, and the catalyst. The second pre-mixed component includes the first species, the second species, and the electrically-conductive filler. Prior to mixing together the first and second components, additional catalyst can be added to the first pre-mixed component. This arrangement can be used when the catalyst has catalytic action that in the presence of heat catalyzes a reaction between the first and second functional groups, and the electrically-conductive filler adversely affect the catalytic activity of the catalyst.

The invention also provides an EMI shielded substrate. The shielded substrate includes a first electrically conductive substrate, a second electrically conductive substrate adjacent to the first substrate, and a formed-in-place electrically conductive gasket formed on and bonded to a predetermined portion of the first substrate so as to provide an electrical connection and EMI shielding between the first and second substrates. According to one aspect the first substrate is an enclosure and the second substrate is a cover for the enclosure. The first and second substrates can be formed of an electrically conductive material such as metal, metal plated plastic, metal/plastic laminate and composite, coated plastisol, or any combination of these. The gasket can be formed of an elastomer resin and rendered electrically conductive by the incorporation of one or more conductive fillers into the resin. The gasket can include more than one layer, with at least an outer layer being electrically conductive.

According to one embodiment the EMI shielded substrate includes a substrate having an electrically conductive surface, a cover for the substrate, the cover having an electrically conductive surface which corresponds to and is in register with the conductive surface of the substrate, and a formed in place electrically conductive gasket formed on and bonded to a predetermined portion of the conductive surface of the substrate or cover so as to provide an electrical connection and EMI shielding between the substrate and cover upon the mating of the cover to the substrate.

According to another embodiment of the invention a form-in-place EMI gasket is provided that includes a composition formed of a silicone resin, one or more conductive fillers, and a curing agent for the resin. The composition, when mixed and applied to a substrate, will create a form stable, form-in-place gasket capable of providing EMI shielding of from about 10 dB to about 120 dB over a frequency range from 10 MHZ to 12 GHz.

According to another embodiment the invention provides an EMI gasket that is made of a composition formed of a first component which is a primary polymer having end groups that are capable of chemically reacting with each other in the presence of moisture to form a derivative polymer having a longer average chain length than said primary polymer, a second component which is a non-crosslinked elastomer that is not substantially chemically reactive with itself or with said first component, and a third component which is one or more electrically conductive fillers. When the first, second, and third components are intimately mixed, the composition, when maintained in the absence of moisture and other active hydrogen donor materials, is readily extrudable and otherwise conventionally moldable thermoplastic composition. Upon exposure to moisture, however, the composition becomes essentially thermoset.

According to another embodiment, the invention provides a system for forming EMI shielded enclosures. The system includes a support platform, a compound applicator nozzle located above and in register with the platform, a supply of electrically conductive compound connected to the applicator nozzle, and a drive mechanism for moving the nozzle or platform relative to each other in one or more directions of travel. A curing chamber for curing the compound, after application, can be provided.

According to yet another embodiment, the invention provides a process for forming a form-in-place conductive EMI shielding gasket or a substrate that includes the steps of providing a substrate to be gasketed, providing a supply of conductive gasket material, applying the material to the substrate's surface in a predetermined pattern, and curing the material in place upon the substrate.

According to one aspect of all the embodiments herein, a primerless form-in-place gasket is provided.

The invention has broad applicability in form-in-place gasket applications including, but not limited to, application to the mating surfaces of cover pieces for electronic devices such as cellular phones, notebook computers and other devices requiring shielding. Additionally, a gasket can be formed on a removable cover which is fit to an access port of an electronic device.

These and other objects of the invention will become clear from the following description and claims.

Brief Description of the Drawings

Fig. 1 illustrates in planar view a preferred configuration of a form-in-place conductive EMI gasket, having a complex physical structure comprising a series of elongated sections in the x-y axis, on a desired substrate;

Fig. 2 shows in cross section a preferred embodiment of the gasket of Fig. 1;

Fig. 3 shows in planar view a preferred system for forming-in-place an EMI gasket, according to the present invention;

Fig. 4 shows another embodiment of a system of the present invention in cross section;

Fig. 5 shows a cross section of another preferred embodiment of the present invention;

Fig. 6 is a schematic illustration of an extruder apparatus;

Fig. 7 is a representation of a process of forming a bead on each of a plurality of substrates;

Fig. 8 is a representation of the process illustrated in Fig. 7 further including heat curing the beads in place on the substrates; and

Fig. 9 is a representation of a non-electrically-conductive bead formed by a prior art device showing excess material or drool in the bead.

Detailed Description of the Invention

The present invention relates to a form-in-place EMI gasket. Such gaskets are useful when positioned between two adjacent substrates such as a boxed cover, so as to form an electrical bridge or continuity between the two substrates and thereby prevent or reduce the potential for EMI.

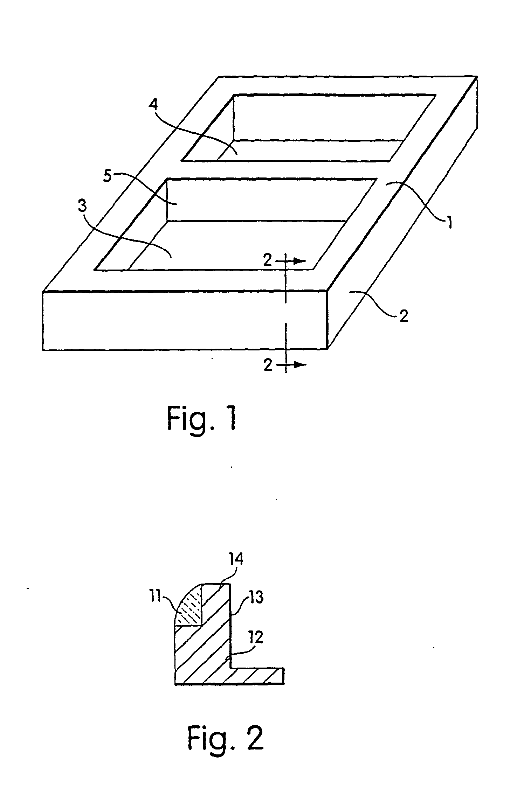

Fig. 1 shows a preferred embodiment of the present invention. The form-in-place conductive gasket 1 is mounted on a preselected section or sections of a substrate 2 which is to be shielded. In Fig. 1, the substrate 2 is a modular enclosure formed of two compartments 3, 4 separated by a wall 5. Such an enclosure can be a cellular phone carcass, a switching box, hard disk drive case, etc. As can be seen, the gasket 1 is formed in place along the edges of the enclosure which will mate with a cover (not shown).

Fig. 2 shows the conductive form in place gasket 11 in cross section as mounted to the enclosure 12. In this embodiment, the area of the enclosure to be gasketed 13 has a shoulder 14 against which the gasket is formed. Other embodiments may not have the shoulder 14, being flat instead, or may use other locating devices such as undercuts, dovetails, channels, etc. into which or against which the gasket may be formed.

The polymeric material that is the precursor is extruded onto a substrate, cured, and exhibits advantageous EMI shielding properties such as bulk resistivity of less than about 0.050 ohm cm. The gasket can be applied to any substrate, in any configuration, easily and in a cost effective manner with a minimal investment for tooling. Moreover, with the use of preprogrammable application equipment, one can store an infinite number of gasket configurations which can be called up and used quickly and repeatedly without the necessity to manufacture a specific die or a mold.

Additionally, it allows for the exact placement of very small diameter gaskets (e.g..030 inch diameter or less) which is difficult to achieve with all but molding.

The word "elastomeric" should be given its usual meaning given the purpose for which the invention is intended. The elastomer bases used in the invention can be thermosetting resins; e.g. resins which to cross-link and subsequently cure either at a critical temperature or in the presence of a curing agent/catalyst such as peroxide, photoinitiator, moisture, etc. Any flexible thermosetting elastomer base is suitable for use in the invention, such as EPDM copolymers, silicone rubbers, fluorosilicone rubbers, urethane rubbers, nitrile, rubbers, butyl rubbers, and mixtures thereof.

Elastomeric thermoplastics may also be used. Thermoplastic rubbers, such as various block copolymers (KRATON™ rubber, NORPRENE™ resin or SANTOPRENE™ resin) are particularly useful. Omission of other elastomers is not meant to specifically exclude their use in the invention. Certain physical or electrical requirements of the application for which the gaskets are intended may dictate that particular elastomeric compositions be used.

The selected material is preferably a fluent, hardenable polymeric material. By this definition is meant a polymeric material that has viscosity characteristics as described above, that can be readily extruded from an extrusion nozzle. The fluent polymeric material preferably has the following representative flow rate characteristics as described below, when the material is extruded through an 0.84mm (0.033 in.) orifice (18 gauge needle), at 1.38 bar (20 psi) the range of flow rates are (depending on changes in viscosity) 0.03-014 gm/min; 2.76 bar (40 psi) the range of flow rates are 0.05-0.25 gm/min at 4.11 bar (60 psi), the range of flow rates are 0.10-046 gm/min. When the material is extruded through a 1,37mm (0.054 in) orifice (15 gauge needle) at 1.38 bar (20 psi) the range of flow viscosity rates were 0.06-0.49 gm/min while at 2.76 bar (40 psi) the range is 0.19-1.25 gm/min and at 4.11 bar (60 psi) the range is 0.36-2.62 gm/min. The fluent, polymeric material should be sufficiently viscous and/or form stable so that it does not slump, sag or run between the time of application and the time of curing. It may be in the form of a paste, a caulk, a gel or viscous fluid. Alternatively, when the material has a fast curing cycle or creates an initially stable material such as a gel or a skinned or foam structure upon application, the material as applied can be a relatively thin or non-viscous fluid.

In addition, the selected resin should form a soft, resilient, compression set resistant gasket even with the addition of relatively high loadings of conductive fillers, if used.

Preferred elastomers that meet the requirements above include silicone rubbers, whether foamed or unfoamed; silicone gels, whether foamed or unfoamed, typically such gels are relative soft silicone rubber which may have been extended with oils or plasticizers or which are only lightly cross-linked; polyurethanes, especially the prepolymer type of urethane in which the prepolymer is capped or terminated with an isocyanate group which when exposed to an activating agent (typically a hydroxy containing group), such as water, amines or alcohols cause the prepolymer to a cross-link; elastomeric thermoplastic rubbers such as DYNAFOAM™ and NORPRENE™ from Norton Co.; SANTOPRENE™ resin from Monsanto, and KRATON™ rubber from Shell Oil. These thermoplastics generally comprise at least a block copolymer, such as SBS or SIS rubber with or without other polymers (polyethylene, polystyrene, etc.) and/or oils or plasticizers. Additionally, various blends of the elastomers can be used as well.

Such polymers are generally known and widely available, see e.g. U.S. Patents 4,931,479, 4,643,924 and EP Patent Application 0326704A.

An EMI gasket can be formed of a composition as taught by EP Patent Application 0326704A by using a two-component polymer system, one which is thermoplastic in nature, the other being thermoset when exposed to moisture or active hydroxyl groups. According to one embodiment the gasket includes the following three components. The first component is a primary polymer having end groups that are capable of chemically reacting with each other in the presence of moisture to form a derivative polymer having a longer average chain length than said primary polymer, such as an isocyanide capped polyester prepolymer. The second component is a non-crosslinked elastomer that is not substantially chemically reactive with itself or with said first component in the presence of moisture, such as a block copolymer e.g. styrene-butadiene-styrene block copolymers. The third component is one or more electrically conductive fillers. The first, the second, and the third components are intimately mixed, and the composition, when maintained in the absence of moisture and other active hydrogen donor materials, form a readily extrudable and otherwise conventionally moldable or coatable thermoplastic composition but, upon exposure to moisture, becomes essentially thermoset. One preferred embodiment of the invention utilizes thermal addition cure systems.

Silicone-based polymeric materials suitable for use include those available from Dow Corning Corporation as SYLGARD™ 527 (Parts A and B), DOW CORNING 3146, those available from GE Silicone as one-part RTV silicone material including primerless adhesive RTV 6802, 6803, 6808, 6809, general purpose adhesive RTV 6702, 6703. 6708, fast-curing primerless adhesive RTV 5812, 5813, 5818 and two-part RTV materials, also Shin-Etsu (Torrance, CA) selfpriming (primerless) KE 1800 T, KE 109 RTV silicones (2-component) or KE 1820, KE 1830. A suitable material can be mixed with one or more conductive fillers to form an EMI material.

The gasket may be rendered electrically conductive either through the use of a conductive filler incorporated into the elastomer base and/or the use of an electrically conductive outer layer formed over a core which may be conductive or nonconductive.

The fillers that are used to impregnate elastomers to make them electrically conductive are well-known in the art. Examples of these fillers include but are not limited to electrically conductive noble metal-based fillers such as pure silver; noble metal-plated noble metals such as silver plated gold; noble metal-plated non-noble metals such as silver plated copper, nickel or aluminum, for example, silver plated aluminum core particles or platinum plated copper particles; noble-metal plated glass, plastic or ceramics such as silver plated glass microspheres, noble-metal plated alumina or noble-metal plated plastic microspheres; noble-metal plated mica; and other such noble-metal conductive fillers. Non-noble metal-based materials are also suitable, including non-noble metal-plated non-noble metals such as copper-coated iron particles or nickel plated copper; non-noble metals, e.g. copper, aluminum, nickel, cobalt; non-nobel-metal-plated-non metals, e.g., nickel-plated graphite and non-metal materials such as carbon black and graphite combinations of the fillers to meet the desired conductivity, hardness and other parameters desired for a particular application.

The shape and size of the electrically conductive fillers is not critical to the present invention. The fillers may be of any shape that is generally used in the manufacture of conductive materials, including spherical, flake, platelet, irregular or fibrous (such as chopped fibers). In making gaskets in accordance with the invention it is preferred that the particle shape be spherical, substantially spherical or irregular. Flake or platelet shaped fillers are preferred when used in forming an outer conductive coating for the foam-in-place gasket.

The particle size of the electrically conductive fillers can be within the range normally used for fillers in conductive materials. Generally the particle size of the one or more fillers is from about 0.250 $\mu$m to about 250 $\mu$m preferably from about 0.250 $\mu$m to about 75 $\mu$m, and most preferably from about 0.250 $\mu$m to about 60 $\mu$m.

The fluent, hardenable polymeric material of the invention has a viscosity of from about 100 to about 10,000 Pa·s about 100,000 to about 10,000,000 centipoise). Viscosity is measured at 25°C using a Brookfield Viscometer (RV series) Heliopath Stand, "F" T-Spindle (1-2.5 RPM), Brookfield Engineering Labs, Inc., Stoughton, Mass. Viscosity can be adjusted by, for example, addition of a silicone fluid.

The amount, or loading, of the one or more electrically conductive fillers in the conductive elastomeric material used in the present invention can vary over a wide range, as long as the electrically conductive filler is present in an amount sufficient to provide EMI/RFI shielding properties. Generally loading of the filler particles in the conductive elastomeric material is from about 10 to about 80 volume percent, preferably from about 20 to about 66 volume percent.

When a conductive outer layer is used to provide the conductivity to the gasket, it may be in the form of a plating, a coating or a film. Plated layers, such as silver plating, are not preferred as the platings tend to be rigid and crack under compression. Films, such as a conductive filled polyethylene or polyimide, may be used.

Preferably, the outer conductive layer is some form of conductive coating. More preferably it is a conductively filled resilient coating. Such coatings can and preferably are based upon the same elastomer resin that is used to form the inner layer. Preferred coatings include silicone, polyurethane, acrylic and epoxy resins filled with one or more of the conductive fillers in the same size range and amounts as described above.

Other fillers and ingredients may also be added to the elastomer base if desired. Such fillers include microwave absorbing materials, thermally conductive fillers, inert or reinforcement fillers such as silicas and pigmentation fillers, also glass or polymeric microspheres. Additionally, curing agents, cross linking agents, flame retardants, diluents, solvents or dispersion aids, etc., may be added as is well known in the art to form the desired conductive elastomeric material. The elastomers may in addition comprise other compounds, such as plasticizers, extender oils, softeners, tackifiers catalysts, blowing agents or other agents that impart desired properties to the cured gasket.

Typically, the gasket should have a Shore A hardness (as measured by ASTM standards) of less than 90, preferably between 5 and 80, more preferably 5 and 50 and more preferably between 5 and 40. The properties of the gasket will vary depending upon the resin chosen, whether it is foamed or not, the amount of filler contained therein and the other constituents (oils, plasticizers, reinforcing fillers etc.) that may be added.

a typical form-in-place gasket should have a low closure force, e.g. a force of less than about 893g/cm (5 pounds/linear inch), preferably less than 536g/cm (3 pounds), and more preferably less than 179g/cm (1 pound) to deflect the gasket sufficiently to ensure proper electrical continuity between the two adjacent substrates.

The gasket should be capable of being dispersed by automated equipment (if so desired) in diameters ranging from about 0.25mm to 6.35 mm (.010 to 0.25 inch) wide and aspect ratios as from about .25 to 1 to about 3 to 1.

EMI Shielding effectiveness should be at least 10 dB, preferably at least 20 dB over a range of frequencies from about 10 MHZ to 12 GHz. More preferably, it should provide an EMI shielding effectiveness of from about 10 dB to 120 dB, preferably from about 20 dB to 80 dB, over a frequency range of from about 10 MHZ to 12 GHz, preferably from about 200 MHZ to 10 GHz. Shielding effectiveness will of course vary with the amount of conductive material present, the deflection imposed upon the gasket and the test method used. All shielding effectiveness values above assume a typical loading of conductive materials as referenced above, with at least 10% deflection, preferably 10 to 50% deflection and standard MIL-G-83528 test procedures.

The process of applying such form-in-place conductive elastomers preferably includes the use of automated equipment such as robotic applicators, such as x-y, x-y-z and other such multiaxis or rotational type of applicators; hand applicators such as caulking guns; transfer applicators and other such processes.

Preferably, the process relates to the formation of an elastomer which is capable of being formed in place, applying the elastomer to a substrate along a predetermined pathway and curing the elastomer in place. This means that a free-form polymeric material, for example a free-form polymeric thermal addition cure system, is extruded onto a substrate and cured. "Free-form" means that the extrudate assumes a desired shape and is cured without the use of a mold. The extrudate can be cured without a mold as well, preferably at atmospheric pressure.

According to a preferred embodiment, excellent adhesion of the materials and gaskets of the invention to substrates onto which they are applied and cured is realized without the use of primer. If desired or required, however, due to the elastomer resin selected and/or its adhesion to a certain substrate, a bonding agent or primer may be used. For example, some silicone compositions are known to have poor adhesion properties, especially to metal substrates a primer, such as a functionalized silane, silicate ester, a cyanurate or a silicone based adhesive may be used to cause the silicone composition to adhere to the metal substrate. In the preferred embodiments, even when primerless materials are used the force of cohesion within the gaskets formed is less than the large force of adhesion to the underlying substrate. Thus good bonding to substrates is obtained.

One preferred process is to use a stationary support or table to which the substrate to be gasketed is fixed in place, a movable applicator, such as a programmable x-y or x-y-z nozzle, which is connected to a supply of form in place elastomer, is positioned adjacent and preferably above the substrate and then caused to travel along a predetermined path, applying the elastomer to the portion of the substrate over which it travels in a desired amount. The elastomer then is cured.

Alternatively, the nozzle may be stationary and the table may be caused to move in two (x-y), three (x-y-z) or more planes of movement.

In a further embodiment, both the nozzle and the table may move in one or more planes relative to each other. One example is where the nozzle moves in two planes (x-y) and is rotational as well and the table is capable of vertical (z) movement. Other variations and embodiments can be used as well.

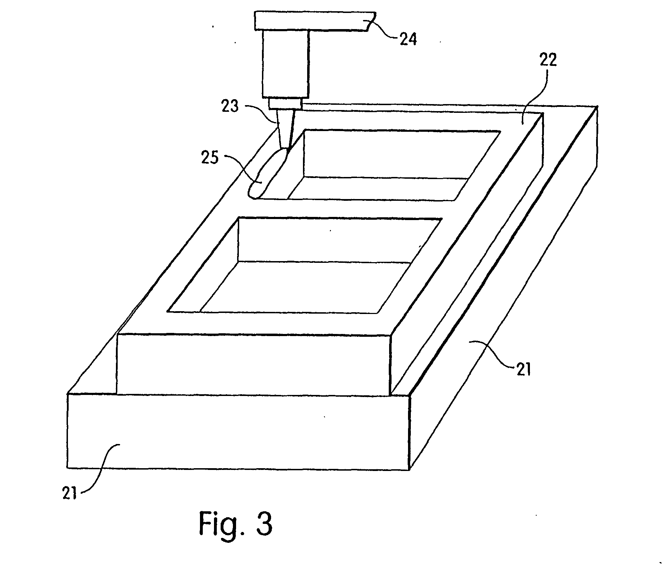

a typical system for performing the process is shown in Fig. 3 wherein a support platform or table 21 has a substrate to be gasketed 22 mounted upon it. An applicator, such as the lining dispenser 23 is located over the platform 21. The dispenser is connected to a supply (not shown) of form in place elastomer via a conduit 24.

The dispenser 23 is capable of moving in at least two planes of motion relative to the platform, such as in the x and y axes. Preferably, it is capable of moving in three planes of motion (x, y, z) and may also be rotational so as to accommodate changes in the height or the angle of the substrate 21 over which it passes and applies the elastomer to form a gasket 25 at a desired position.

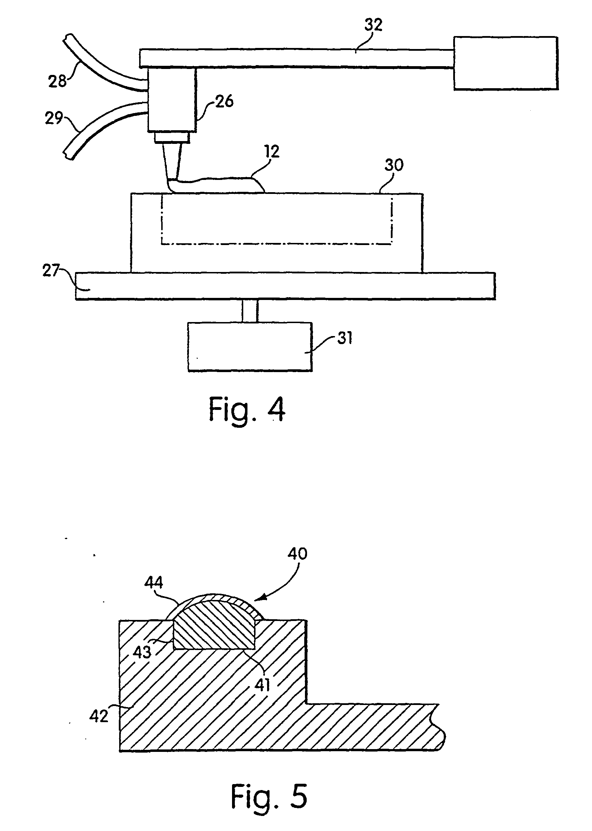

Fig. 4 shows another typical system in which the dispenser 26 and the table 27 move relative to each other. Also in this instance, the nozzle has two supply lines 28, 29 which allows for the use of two component systems such as urethanes or the introduction of a gaseous component (air, $CO_2$, nitrogen) into the elastomer just before application so as to form a foamed structure. The table 27 to which the substrate 30 is mounted is moved in one or more directions (x, y and/or z) by a drive mechanism as represented by box 31. The nozzle is moved via a similar drive mechanism 32.

One method of forming the form in place gasket is to mix a silicone rubber, preferably in the form of a low Shore A siloxane polymer with electrically-conductive filler in an amount sufficient to provide EMI shielding. The mixture is then mixed with additional silicone rubber and/or a curing agent or catalyst and then added to a syringe applicator mounted on an x-y applicator arm. The material is then dispersed along a peripheral edge of a substrate, such as a cellular phone housing where it cures in place.

Another method is to form a nonconductive elastomer gasket layer, such as by the process described above and then forming a conductive outer layer over the nonconductive core via spraying, coating, painting or dipping a conductive outer layer onto the core. Fig. 5 shows such an embodiment. The gasket 40 is contained in a channel 41 formed in a substrate 42. The inner layer 43 is covered at least partially with a conductive outer layer 44. The inner layer 43 is preferably nonconductive. However, if desired, it could be conductive, containing e.g. carbon black as a filler.

Alternatively, the nonconductive core can be coated with an adhesive layer which then is flocked with conductive fibers, as taught by U.S. Patent 5,115,104, which is incorporated herein in its entirety.

The gasket may be cured by any of the mechanisms commonly used for the selected polymer so long as the cure does not adversely affect the slump properties of the gasket between application and cure, and/or the physical or electrical properties of the cured gasket.

Some elastomers such as prepolymer based polyurethanes are basically self-curing in that once the reaction between the isocyanate group and hydroxy group begins, it typically continues until one or both groups are expended.

Other elastomers, such as some silicone and thermoplastic rubbers use chemical curing agents such as peroxide, sulfur, zinc or amines and/or heat to cross-link and cure the resin.

Photocurable resins may also be used via the incorporation of a light sensitive curing agent or photoinitiator which upon exposure to a certain wave length of light (UV, etc.) causes the resin to cross-link and cure.

Some resins use heat to cure. In a particularly preferred embodiment of the invention, a polymeric thermal addition cure system in the form of a hardenable fluent polymeric extrudate is cured in an oven. In addition, in heat cure systems one may warm a substrate before, during or after application (especially if it is metal) of hardenable fluent polymeric material in order to hasten the cure and avoid problems of a cool substrate coating as a heat sink and drawing away heat from the resin. Alternatively, the resin can be heated in an extruder container or passage such as a nozzle just before application. The use of hot air or infrared heaters adjacent the substrate may be used.

Hot melt resins such as those based upon KRATON™ rubbers typically need to cool in order to set. Affirmative cooling of the substrate in this instance may be useful. Those hot melts which contain a cross-linking agent may actually need to be kept at an elevated temperature (albeit it below the melting point of the resin) in order to cross-link.

In accordance with a particularly preferred embodiment of the invention, a polymeric thermal addition cure system, and an electrically-conductive filler, form an EMI shielding material which can be extruded and then heat cured. Polymeric thermal addition systems are known, and many such systems suitable for use in the invention are cured through reaction between functional groups on adjacent molecules, which functional groups and molecules can be the same or different. For example, the invention finds utility with a single species that is a polymer that can be cross linked, chain extended, or both.

First and second species having first and second functional groups, respectively, can be reacted as well to cure and harden a fluent polymeric material. The first species is generally polymeric, and the second species a cross linker, although both the first and second species can be polymeric. The first and second species have adequate functionality such that a thermally-activated cross linking reaction results in hardening of the material to an extent that a gasket having mechanical properties desirable in an EMI shielding gasket results.

The first species is preferably a polymeric species of a size and structure that results in the material being fluent and extrudable, generally with a viscosity of from about 500 to 1,000 Pa·s (about 5,000 poise to about 10,000 poise) at 25°C. The polymeric species can be a linear, branched, or radial homopolymer; random copolymer, or block copolymer, including polymeric species described above, and can include terminal reactive functional groups, internal (non-terminal) reactive functional groups, or both. The first species can include phenylmethylvinyl and divinylmethyl materials. According to a particularly preferred embodiment, the first species is a linear vinyl-terminated siloxane polymer, such as vinyl-terminated polydimethyl siloxane, and the second species is as hybrid cross-linker such as a hydride terminated siloxane, or a methylhydrodimethylsiloxane copolymer with 20-60% methyl hydrogen. A catalyst, such as a platinum catalyst, typically is necessary to catalyze the addition cure reaction between the first and second species. Platinum catalysts are known to those of ordinary skill in the art, typically embodied as organoplatinum species.

Siloxane-based polymeric thermal addition cure systems are commercially available, for example from Dow Chemical, GE Silicone, or Shin-Etsu Company: Such systems are generally sold as a two-component system, the first component including a vinyl-containing siloxane and about 5-10 ppm platinum catalyst, and the second component containing a hydride functional siloxane and a vinyl-containing siloxane. The first and second components are mixed and heat cured, resulting in a form-stable material.

The polymeric thermal addition cure system becomes essentially thermoset upon exposure to a temperature of at least 85°C for a period of time of at least 30 min. Typically, temperatures of from about 85°C to about 180°C are employed, and heat is applied to the system for period of time ranging from about 30 minutes to about 160 min. Preferred systems are cured at about 150°C for about 30 minutes, at about 120°C for about 60 minutes, or at about 85°C for about 120 minutes. Those of skill in the art can adjust the time and temperature of curing to suit a particular system. For example, if a temperature as high as 250°C is used, the curing time may be as short as 1-5 minutes.

Preferred polymeric addition cure systems, such as siloxane-based systems, will adhere to a substrate upon which they are cured without the use of a primer. Substrates to which the system will adhere when cured thereon include plastics, metals, ceramics, silica, and the like.

In accordance with the invention, an electrically-conductive material is mixed with the first and second components of a two-component thermal addition cure system, and when the components are mixed and heat cured, a form-stable EMI shielding material results. When a silver-based electrically-conductive material (such as silver powder, silver-plated metal, ceramic or polymeric particles, or silver-impregnated particles) is used, however, the silver acts to adversely affect the catalytic activity of the catalyst, especially a platinum catalyst. Therefore, when the above-described first and second pre-mixed component are stored, over time the silver-based filler inhibits the platinum catalyst to adversely affect the catalytic activity of the catalyst. Thus, the replenishment of catalyst is controlled in accordance with the invention to counteract the conductive filler poisoning of the catalyst resulting from storage and use of the system.

According to a particularly preferred embodiment of the invention, a method involves providing several pre-mixed components and mixing together the components to form EMI shielding material that can be extruded to form a gasket. The components are formulated such that predetermined amounts of each are blended together prior to extrusion, where the predetermined amounts are conveniently deliverable and blendable. For example, the components can be prepared such that a ratio of the first to the second of approximately 1:1 can be blended prior to extrusion. a three-component system is provided that includes one pre-mixed component that can include the first species, the electrically-conductive filler, and the catalyst, a second component can include the first species, the second species, and the electrically-conductive filler, a third component can be provided that includes the catalyst in a suitable carrier, such as a silicone fluid or silicone-compatible fluid, an organic solvent such a toluene, alcohol, or the like, or one of the first or second species, a cure accelerator, such as sold by Dow Corning as Q3-6559, as well as other cure accelerators having relatively high catalyst content, is suitable for use as the catalyst-replenishing third component. The method can involve mixing the first and second components together and then adding the third component prior to extrusion or mixing the first component with the third component, then adding the second component prior to extrusion. While not preferred, the second and third components can be mixed, followed by addition of the first component prior to extrusion.

According to another embodiment of the invention, a two-component system is provided that includes one pre-mixed component that can include the first species, the second species, the electrically-conductive filler, the catalyst, and an inhibitor. The inhibitor prevents reaction between the first and second species at room temperature, but at curing temperatures is volatilized, allowing reaction between the first and second species. A second component includes the catalyst in a suitable carrier. According to this embodiment, when a hydride-containing siloxane is used in the curing reaction, it is advantageously replenished if the system is stored for longer than one day. The amount of hydride needed to replenish the system is dependent upon the length of time of storage. According to this embodiment, the method involves mixing the first and second components together just prior to extrusion.

According to one embodiment, polymeric microspheres can be added to the polymeric addition cure system prior to curing. Such polymeric microspheres are known in the art and are formed of phenolic material, acrylonitrile-based material, or the like, depending upon the physical properties desired. Such microspheres can be made to be compressible, such that upon compression the viscosity of material containing the sphere drops. The spheres can also be made to contain a volatile species such as a hydrocarbon core contained within a polymeric shell, and upon exposure to heat, the hydrocarbon expands to expand the sphere. Acrylonitrile microspheres of 5-200 $\mu$m size, averaging 25 $\mu$m, are suitable for use in the invention.

An EMI shielding gasket is formed by extruding from an extrusion head a fluent polymeric material that is a blend of a three-component polymeric thermal cure system including electrically-conductive filler particles.

The three-component system is formulated as follows, a first pre-mixed component is a 12.25 parts/wt vinyl terminated siloxane polymer and platinum catalyst containing 48 parts/wt silver-plated copper particles (electrically-conductive particles), and 0.2 parts/wt 25 $\mu$m acrylonitrile microspheres a second pre-mixed component is a mixture of a 12.5 parts/wt hydride-terminated siloxane polymer and vinyl-terminated siloxane polymer, 48 parts/wt silver-plated copper particles, 0.2 parts/wt 25 $\mu$m acrylonitrile microspheres, and 0.2 parts/wt fumed silica. The first and second components, absent the microspheres, the electrically-conductive particles, and the fumed silica, are available commercially from Dow Corning as SYLGARD™ 527A and 527B. In other examples, GE Silicone 6196 (Parts a and B), or Shin-Etsu KE 1800T and KE 109 RTV silicones, respectively, are used. Into the first and second components is mixed a third component that is 0.25 parts/wt of a cure accelerator containing a platinum catalyst, available from Dow Corning as Q3-6559, and 0.75 parts/wt of a silicone fluid, available from Dow Corning as low-viscosity 200 fluid.

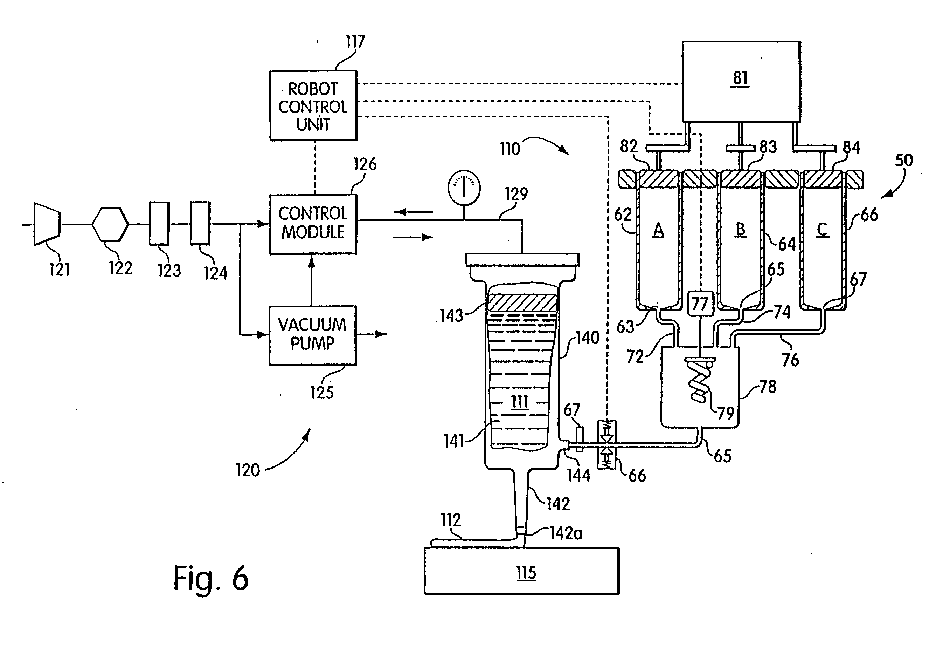

Predetermined quantities of the first, second, and third components are loaded into respective containers of a material supply and extrusion system illustrated in Fig. 6 and described more fully below. The percentages by volume of the first, second, and third components added to form the fluent, polymeric mixture are approximately 19, 19, and 1, respectively, according to one embodiment. The first and third components can be mixed prior to addition of the second component. The product can be heat cured in place, for example at a temperature 138°C for one-half hour.

Next is described apparatus for forming a bead of curable material on a substrate. Any of the materials described above, in addition to other materials, can be extruded using the apparatus. The apparatus can be used to extrude material evenly, rapidly, and without overrun. In a preferred embodiment of the invention, the apparatus comprises an extruder having a chamber for holding a supply of electrically conductive material having a viscosity from 100 through 10,000 Pa·s (100,000 through 10,000,000 centipoise). Preferably the material has a viscosity from 1,000 to 4,000 Pa·s (1,000,000 to 4,000,000 centipoise). An extrusion head is mounted on the extruder and is connected with the chamber for extruding the bead of EMI shielding material on the substrate, the head is movable with respect to the substrate. A vacuum pump provides a negative gauge pressure and a compressor provides a positive gauge pressure. Each are connected to a control module which is adapted to control the amount of air pressure acting on the EMI shielding material. The air pressure supplied to the extruder can be varied and is adjusted depending on the speed of the extrusion head, the amount of EMI shielding material in the extruder chamber the flow rate characteristics of the material, and the viscosity of the EMI shielding material. The bead formation can be precisely controlled by varying the air pressure very rapidly. To terminate the bead formation, the pressure on the fluent polymeric material is rapidly reduced by connecting the conduit to negative gauge pressure. Once the bead has been formed on the substrate, the electrically conductive material is subjected to a curing process to cure the EMI shielding material.

Fig. 6 shows a schematic diagram of an apparatus indicated generally at 110, for forming a bead on a substrate which may be cured after forming. The apparatus has an extruder 140, a pressure supply system indicated generally at 120 and a material supply system indicated generally at 50.

The apparatus 110 provides a predetermined quantity of fluent polymeric material 111 supplied to the extruder 140 which has a chamber 141. The fluent polymeric material 111 is forced out of the extruder chamber 141 through an orifice 142a of an extrusion head 142 by air pressure, which is supplied by the pressure supply system 20, on the surface of the fluent polymeric material 111. The pressure supplied to the extruder chamber 141 is adjusted by a control module 126 and can be varied. As the fluent polymeric material is forced through the extrusion head 142, the head moves along a predetermined path to form a bead 112 of polymeric material. The bead 112 which is formed along the desired path is cured to form the final EMI shielding gasket. The bead formation is terminated as where a continuous encircling gasket is formed, by reducing the pressure in chamber 141, preferably very rapidly, to a negative gauge pressure, which can be as low -0.81 bar (-0.9 atm), or lower.

The extruder 140 is mounted on a robotic applicator which is a commercially available programmable X, Y, Z coordinate machine. In the preferred embodiment, the head moves relative to the position of a substrate 115, which is fixed in place during the extrusion process, a robotic control unit 117 controls the movement of the robot and the extrusion apparatus. A suitable robotic applicator is available from Robotics Inc. located in Ballston Spa, New York.

The material supply system 50 is designed to feed a predetermined amount of material into the extruder chamber 141. The material which is being extruded can be a hardenable, fluent polymeric material. By this definition is meant a polymeric material that has viscosity characteristics as described above, that can be readily extruded from an extrusion nozzle, and that is thermosetting, thermoplastic, or otherwise hardenable. The material can be a one-component elastomer or resin that is cured via heat, moisture, light, or chemical means. Any flexible setting resin is suitable for use in the invention, such a EPDM copolymers, silicone rubbers, fluorosilicone rubbers, urethane rubbers, nitrile rubbers, butyl rubbers, and mixtures thereof. Thermosetting or thermoplastic materials can be used. The selected material should be sufficiently viscous and/or form stable so that it does not slump, sag or run between the time of application and the time of curing. It may be in the form of a paste, a caulk, a gel or viscous fluid. Alternatively, when the material has a fast curing cycle or creates an initially stable material such as a gel or a skinned or foam structure upon application, the material as applied can be a relatively thin or non-viscous fluid.

The selected resin should form a soft, resilient, compression set resistant gasket even with the addition of relatively highloadings of conductive fillers, if used. Preferably the final gasket is elastomeric and can have a continuous encircling configuration. When the polymeric material is in its fluent state, it preferably can be compressible to about 95% of its uncompressed volume when positive gauge pressure in the operational range of the machine is applied. When the polymeric material is compressible, part of the pressure applied to the extruder chamber during the extruding operation is absorbed by the material as it compresses. This results in a lag time and a sluggish response to the application of pressure in the extrusion process. The sluggish response further complicates the termination of the extrusion of the bead because of the energy which is stored in the compressed material. Of course, the process and apparatus of the invention can be practiced with an incompressible fluent polymeric material.

The fluent polymeric material preferably has the following representative flow rate characteristics as described below, when the material is extruded through 0.84mm an (0.033 in) orifice (18 gauge needle), at 1.38 bar (20 psi) the range of flow rates are (depending on changes in viscosity) 0.03-014 gm/min; at 2.76 bar (40 psi) the range of flow rates are 0.05-0.25 gm/min, at 4.116 bar (60 psi) the range of flow rates are 0.10-046 gm/min. When the material is extruded tnrough a 1.37 mm a (0.054 in) orifice (15 gauge needle) at 1.38 bar (20 psi) the range of flow viscosity rates were 0.06-0.49 gm/min while at 2.76 bar (40 psi) the range is 0.19-1.25 gm/min and a 4.11 bar (60 psi) the range is 0.36-2.62 gm/min.

The viscosity of the fluent polymeric material is between about 100 and about 10,000 Pa·s (about 100,000 and about 10,000,000 centipoise). Preferably, the range is between 1,000 and 4,000. The viscosity is measured by a Brookfield Viscometer (RV Series), Heliopath stand with an "F" T-spindle 1-2.5 rpm. The viscometer is available from Brookfield Engineering Labs, Inc., Stoughton, MA.

The Polymeric Material Supply System

The material can be supplied in three constituent parts which are mixed prior to extrusion. As described above, the components could have a limited shelf life and provide the highest quality bead when mixed shortly before the extrusion process. The components can be mixed on-line, that is, supplied to the extrusion apparatus in component parts and subsequently mixed in the apparatus. Alternatively, the components can be mixed off-line and then supplied to the extrusion apparatus ready to be extruded. Alternatively, the invention can be practiced with a single component fluent material which is inserted into the extrusion chamber.

As shown in Fig. 6, constituent material A, B and C are inserted into elongated, tube, cylindrical chambers 62, 64 and 66 respectively. As an example of a three-constituent combination which would be combined to form the fluent polymeric material, A can contain a resin, B can contain a cross-linking agent, and C can contain one or more additives such as polymeric microspheres, silicone fluid, cure inhibitor, catalytic cure accelerator, fumed silica, colorant, or the like, carried in a suitable carrier including the resin or the cross-linking agent. Resins and cross-linking agents, such as siloxane-based resins and cross-linking agents, are known. A proportioning pneumatic cylinder 81 controls the motion of three rams 82, 83, 84 which sealingly slide within one end of each of the chambers 62, 64, 66, respectively. The proportioning cylinder 81 is controlled by the robotic control unit 117. Each ram is adapted to individually and independently slide within the cylinders to force a predetermined amount of component material out of the cylinder through orifices 63, 65, and 67 of cylinder 82, 83 and 84 respectively. Conduits 72, 74 and 76 connect each orifice 63, 65 and 67, respectively, to an elongated, cylindrical mixing chamber 78.

The constituent materials are then mixed in the mixing chamber 78 by a dynamic mixer 79 which in the preferred embodiment is an elongated helical screw. The dynamic mixer 79 is rotated by a motor 77 which is controlled by the robotic control unit 117. The mixing chamber 78 is connected to the extruder chamber 141 by a conduit 65. A valve 66 is disposed along conduit 65 to control the flow of material such that a predetermined amount of polymeric material is allowed to fill the chamber. The valve 66 is shown to be a pinch valve, of course one skilled in the art will recognize the wide variety of valves which are suitable for the purpose of controlling the flow of fluid through conduit 65 and for making sure a predetermined amount of fluent polymeric material flows into the chamber 141. A pressure transducer 67 located between the valve 66 and the cylindrical extruder chamber 141 operates to monitor the pressure in the cylinder.

In a second mode of operation of the extruding apparatus the material 111 is formed from only two combined components. The two components are placed in cylinders such as 62 and 64 and then are mixed in the mixer chamber 78 by the dynamic mixer 79. When two components are used to form the fluent polymeric material, one component could be a mixture of resin and cross-linker and the other component could be catalyst, or one component could be a resin and the other a mixture of the cross-linker and the catalyst, or other formulation.

A third mode of operation of the extruding apparatus is a single component system. In this mode of operation, the single component is placed into a single cylinder and fed through the conduit 65 directly. In some cases it may be advantageous to feed the single component material through the mixer chamber 78 and mixed by the dynamic mixer 79 to ensure a homogenous mixture is fed to the extruder chamber 141.

The Extruder

The cylindrical extruder chamber 141 is adapted to hold fluent polymeric material. An air conduit 129 is fluidly connected to the upper portion of the cylinder and provides air pressure to the chamber 141. A cap 143 is slidingly received in the chamber and separates the pressurized air from the fluent polymeric material, thus keeping the fluent polymeric material free from foreign particles which may be in the air. The chamber also has an inlet 144 through which the fluent material flows from the conduit 65. In the preferred embodiment of Fig. 6, the extruder chamber 141 has a volume of about 30 cc.

At the lower end of the extruder 140 is the extrusion head 142 which has an orifice 142a through which the material is extruded to form the bead. The extrusion head, also known as a needle, has an orifice diameter of about 0.64mm (.025 in) to about 2.29 mm (090 in.) Preferably, the diameter is about 0.84 mm (.033 in) The needle has a decreasing diameter along the axial length towards the orifice to enhance the material flow properties though the needle.

The Pressure Supply System

Again with reference to Fig. 6, the extrusion of the polymeric material 111 is controlled by the pressure supply system 120 which is adapted to provide both a positive and negative pressure to the extrusion chamber 141. An external source such as an air compressor 121, provides a source of positive pressure for the system. Any commercially available air compressor which supplies 11 bars (160 psi) of pressure is suitable for use. The air compressor is fluidly connected to a gas pressure regulator 123 which controls the pressure of the air supplied to the system. This pressure regulator 123 is used to provide broad control of the pressure supplied to the system, and generally does not change during the operation of the extrusion process. An air filter 122 is disposed between the air compressor and the pressure regulator to clean the air which is supplied to the system. A solenoid valve 124 is provided on the pressure line to isolate the pressure from the system at desired intervals during the bead extrusion process.

A vacuum pump 125 is provided in the system 120 to supply a negative pressure or vacuum to the extrusion chamber at predetermined intervals in the extrusion process, for example, when the bead formation is to be terminated as after formation of a continuous encircling bead which is to be cured to form as gasket. The vacuum pump is commercially available and provides a vacuum of about -0.91 bar (-0.9 atm.) The vacuum pump is powered using the pressure from the air compressor in a manner well known to those skilled in the art.

A control module 126 receives both the positive pressure supplied by the air compressor 121 and the negative pressure supplied by the vacuum pump 125 and supplies a selected pressure to the extruder chamber 141 through a fluid line 29. A pressure gauge (not numbered) is disposed between the control module and the extruder chamber. The control module responds to a signal from the robot control panel and is a 24 volt DC binary pressure converter. The control module used in the preferred embodiment is an ABR Regulating valve which is available from Parker Hannifin, of Cleveland, OH. The pressure supplied to the extrusion chamber by the control module varies at 25 increments of positive pressure and 25 increments of negative pressure. The response time of the control module is 20 milliseconds which facilitates a quick response to a start or a stop command from the robot control unit.

Because both the control module 126 and the position of the extruder head 142 are controlled by the robot control unit 117, the control unit can vary the pressure applied to the material by the pressure control module while varying position or speed of the extruder head. For example, the command module can reduce the pressure applied to the material 111 in the extruder chamber 141, when the robotic applicator head slows down to apply a bead to a curve on the substrate, thus, the flow of material out the extrusion head is able to correspondingly slow down. Additionally, the control module can control the pressure to preferably maintain constant desired extrusion pressure while accounting for variations in the required applied pressure due to the diminishing volume of the material in the extruder chamber 141 as the material is being extruded. Typically, the force required to extrude the fluent polymeric material out a needle of 0.84mm (0.033 in) diameter is between 40 and 160 psi.

When it is desired to terminate the formation of a bead the control module 126 reduces the pressure supplied to the fluent polymeric material 111 by connecting the vacuum pump 125 to the chamber. The control module can control the amount of negative gage pressure in 25 increments varying from no vacuum to the maximum vacuum available from the vacuum pump. The vacuum pump enables the bead termination to be controlled with great precision.

Having described the apparatus, a representative method of operation is now provided. The constituent components of the fluid polymeric are placed in the chambers 62, 64 and/or 66. For example, chamber 62 can contain a first pre-mixed component including a vinyl-terminated siloxane polymer, a catalyst, and electrically-conductive particles. Chamber 64 can contain a second pre-mixed component including a hydride-terminated siloxane polymer and vinyl-terminated siloxane polymer, and electrically-conductive particles. Exemplary first and second components, absent the electrically-conductive particles, are available commercially from Dow Corning as SYLGARD™ 527A and 527B. Chamber 66 can contain one or more additives as described above (microspheres, fumed silica, viscosity-adjuster, electrically-conductive particles, cure inhibitor, cure accelerator, or the like).

A proportioning pneumatic cylinder responds to a command signal supplied by the robot control unit to actuate rams 82, 83, and/or 84 to slide into the chambers 62, 64 and/or 66 so that a predetermined amount of material is fed into the mixing chamber 78 and mixed in a dynamic mixing process by a mixer 79, to form a hardenable, fluent polymeric material which can be cured, by heat according to a preferred embodiment, after extrusion.

The material then flows through conduit 65 when the valve 66 is opened by the robotic control unit. The valve 66 controls the amount of material which flows into the extruder chamber 141. When a predetermined amount of material is fed into the extruder chamber 141, the valve 66 is shut. Typically, the amount of material which is fed into the extruder chamber 141 is enough for at least several minutes of operation of the machine. Once the valve 66 is shut the pressure from the air compressor is supplied to the extrusion chamber by the operation of the control module 126. As the pressure is increased a sufficient amount so that the material is extruded out the extruder head, the extruder head simultaneously moves along the predetermined path where a continuous encircling bead is to be formed. As indicated above, the speed of the extruder head can be varied while simultaneously varying the pressure behind the pressure in the extrusion chamber by the control module 126, this provides for precise control of the bead formation process.

In a preferred embodiment of the invention, for example using the apparatus described above, the process for forming a FIP electrically conductive EMI shielding gasket forms a gasket having a cross-sectional area of preferably about 0.13 mm$^2$ (0.0002 in$^2$) to about 10.08mm$^2$ (0.01563 in$^2$) and which gasket is formed by extruding a fluent organic polymeric material which has electrically conductive particles disbursed therein, with the polymeric material acting as a binder. The material is extruded through an extrusion head by the force of pressurized gas. The rate of extrusion is controlled by varying the air pressure applied to the surface of the material within the extrusion head. The organic polymeric material selected to be extruded preferably has a viscosity in the range of between 100 and 10,000Pa·s (100,000 and 10,000,000 centipoise) measured at 25°C by a Brookfield Viscometer. As the material is extruded from the extrusion head, the head is moved relative to a substrate and a bead is formed on the substrate. The head can preferably move at a speed of from about 12.7 mm/s (0.5 in/sec) to about 1524mm/s (6.0 in/sec) with respect to the substrate during the formation of the bead. The bead is preferably formed with a precision of about 0.05mm (0.002 in.) in height or width. The bead is precisely formed by varying the air pressure within a range of about 11.03 bar (160 psi) of positive pressure to about -0.91 bar (-0.9 atmospheres (atm)) of negative pressure on fluent polymeric material to start and stop the bead being extruded.

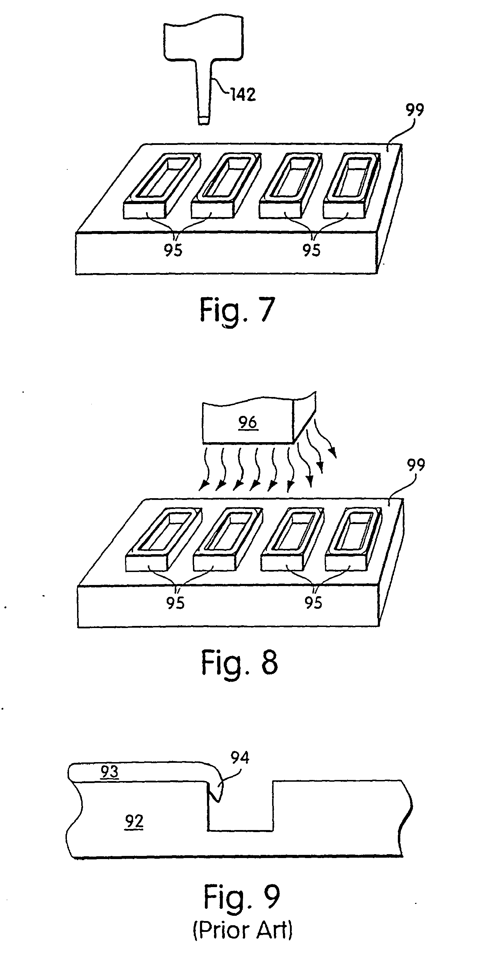

As shown in Fig. 7, several separate substrates or parts 95 can be located on a pallet 99 and the robotic extrusion head 92 can be programmed to form a bead in predetermined locations along the edge of the individual parts. Four parts 95 are shown on the pallet 99 in Fig. 7, it should be recognized that as few as one or as many as parts which can conveniently fit onto a pallet can be used. In the current design, the pallet remains stationary while the bead is being extruded by the extrusion head. It should be recognized that an alternative design could be to program the tables so that the pallet moves along a predetermined path so that a stationary head can deposit the bead on the parts 95. The parts 95 are shown in Fig. 7 as having a bead only in the X and Y direction, it should be recognized that the device can deposit a bead along the X, Y and Z axis. After each part on the pallet has been supplied with a bead, the pallet is moved to an oven 96 for heat curing, as shown in Fig. 8. Typically, the heat cure process will be of a temperature 150°C for about a half hour. The range of cure temperatures could be as low as 75°C and as high as 180°C. After the heat curing, the parts are subsequently cooled.

Fig. 9 shows a non-electrically conductive bead 93 formed on a substrate 92 by a method of the prior art. The "drool" or drip 94 is formed at the termination of the bead 93 because the bead formation process lacks the control of the present invention.

Having described and illustrated this invention in detail, those skilled in the art upon reading the description that numerous modifications may be made without departing from the spirit of the invention. Therefore, it is not intended that the scope of the invention be limited to the specific embodiments described. For example, as indicated above, the extruder head can be made to stay stationary and the table can move along the predetermined path to supply the bead on the substrate. The various chambers, mixers, valves and other components can vary greatly in size, shape and structure for specific applications as will be known to those skilled in the art. While the bead formed can be heat cured when certain materials are used, in some cases the oven can be eliminated and moisture curing used with certain material. Moreover the use of positive and negative gas pressure activation and stopping of any extruded bead of gasket material can be carried out with a wide variety of materials. ,

The description above, and that which follows, is only meant to describe particularly advantageous embodiments of the present invention and as such is only meant to illustrate, not limit it.

Example 1

Part A contains 22.4 parts of silicone resin (Dow Corning 527 Part A), 77.6 parts of silver plated glass spheres, (avg. size 30-50 microns). Part B contains 22.3 of silicone resin (Dow Corning 527 Part B), 0.4 of hydride-terminated siloxane (Dow Corning 184 Part B), 77.3 of silver plated glass spheres (30 to 50 microns average).

Part A and Part B are mixed separately by hand until each is homogenous. Then equal parts are added and mixed by hand until homogenous.

The mixed material is added to a 10cc syringe with a needle tip of 0.84 mm (0.033 in) diameter. The syringe is mounted onto a dispensing head of a CAM-A-LOT™ Model 1818 x-y Positioning/Dispensing System. The material is forced out of the syringe via air pressure of about 6.21 bar (90 psi) in programmed patterns onto an aluminum flange (76.2 mm diameter, 6.35 mm thickness) (3 inches diameter, .25 inch thickness) which is mounted on a stationary table. The sample is cured in a hot air circulating oven for 60 minutes at 100°C.

The flange is cooled and placed in an Instron machine in a modified ASTM D-575 Compression Testing fixture. Electrodes are placed into the flange opposite facing aluminum surface and the sample is compressed at a rate of 0.13mm/minute (0.005 inch/minute) to a total compression of 50% of the original gasket height. During compression, stress, strain and resistivity values are recorded.

Following the compression testing, the flange is removed and bolted to a second flange (with no gasket) until the gasket is compressed to 50% its original height. The assembly is heated in a hot air circulating oven for 22 hours at 85°C. The sample is removed, disassembled and allowed to cool and recover for 30 minutes. The gasket height is remeasured and compression set calculated as:

$$\% \text{ set} = (\text{Original height} - \text{Final height})/(\text{Original height} - \text{Deflected height})$$

The results of those tests are shown in Table 1.

Example 2

A conductive particle-filled, foamed silicone gasket is prepared and tested in the manner set forth in Example 1. The Components of Example 2 are: Part A - 21.6 Silicone RTV Foam (Dow Corning RTV silicone foam #3-6548 A/B), 75.7 Silver Powder (325 mesh), 2.7 Toluene. Part B: 21.4 Silicone RTV Foam (Dow RTV #3-6548 A/B), 74.9 Silver Powder, 1.1 Hydride terminated siloxane (Dow Corning 184 Part B), 2.6 - Toluene. The results are shown in Table 1.

Example 3

A conductive coating over a nonconductive underlayer form-in-place gasket is prepared as follows. The underlayer is prepared and applied as taught in Example 1. The underlayer or core comprises: Part A - 84.2 - Silicone RTV Foam (Dow RTV #3-6548 A/B), 10.5 - Cab-o-Sil (silica), 5.3 - Toluene. Part B - 80.8 - Silicone RTV Foam (Dow RTV #3-6548 A/B), 4.0 - Hydride terminated siloxane (SYLGARD™, 184B), 10.1 - Cab-o-Sil (silica), 5.1 - Toluene.

After formation and cure, a conductive coating formed of silicone RTV, catalyst, solvent and silver coated glass conductive filler is applied by brush to the outer surfaces of the underlayer. The coating is comprised of two parts: Part A - 11.5 - RTV Silicone, 4.71 - Silver Powder, 11.8 - Silver Flake, 29.6 - Toluene. Part B - 100 RTV Silicone.

The Parts are mixed in a ratio of 100 Part A to 1.21 Part B (by weight). The results are shown in Table 1.

Example 4

A stock, linear piece of conductive gasket, known as CHO-SEAL™ 1350 gasket, available from Chomerics, Inc. and formed of a conductively filled silicone rod, 1.52mm (.060 inch) in diameter is tested for compression and resistivity values. The results are shown in Table 1.

Example 5

A conductive flocked form-in-place is formed of a urethane under layer applied and cured

TABLE 1

| EXAMPLE | FORCE/DEFLECTION(lb/inch) (kg·m /17.86) | | | | Electrical Resistance (ohms) at stated Force/Deflection (1b/inch) (kg·m/17.86) | | | | Compression Set (%) |
|---|---|---|---|---|---|---|---|---|---|
| | 10% | 20% | 30% | 40% | 10% | 20% | 30% | 10% | |
| 11 | .5 | 1.5 | 2.7 | 4.3 | .060 | .020 | .011 | .001 | 13 |
| 12 | .7 | 2.2 | 4.0 | 6.2 | .050 | .010 | .007 | .002 | 50 |
| 13 | .3 | 1.3 | 2.5 | 4.0 | .063 | .024 | .018 | .016 | 41 |
| 14 | 2.4 | 4.9 | 8.4 | 13.7 | .037 | .016 | .010 | .007 | 30 |

as described in Example 1. The outer layer of the urethane under layer is coated with a flocking adhesive which in turn is covered by a silver plated nylon flock as taught by U.S. Patent 5,115,104. The flocked gasket is placed in a hot air circulating oven for 10 minutes 93.3°C at (200°F) to cure the adhesive. The flocked gasket is found to provide EMI shielding over a wide range of frequencies.

Example 6

A urethane form-in-place conductive gasket is prepared, assembled and tested according to the procedures of Example 1. The gasket is formed of 100 grams - urethane prepolymer, 3 grams - activator, 360 grams - silver powder, 1.5 grams - silica (as a reinforcing filler). The gasket is applied to and adhered to a substrate. The gasket is found to provide adequate EMI shielding over a wide range of frequencies.

**Claims**

1. EMI shielding material comprising:

   a hardenable, fluent polymeric thermal addition cure system;
   a catalyst having catalytic activity that in the presence of heat catalyzes a reaction in the polymeric thermal addition cure system that causes the system to cure and harden,
   an electrically-conductive filler adversely affecting the catalytic activity of the catalyst by poisonning catalyst, and the catalyst being present in an amount sufficient to retain said catalytic activity.

2. EMI shielding material as in claim 1, wherein
   said material has a bulk resistivity of less than 0.050 ohm cm, and being readily extrudable and remaining so upon storage at room temperature for a period of up to at least one week, but upon exposure to a temperature of at least 85 °C for a period of time of at least 30 minutes becoming essentially thermoset.

3. EMI shielding material as in claim 2, wherein the polymeric thermal addition cure system comprises:

   a first species having a first functional group;
   a second species having a second functional group that is reactive with the first functional group in the presence of the catalyst and heat; and
   the catalyst has catalytic action that in the presence of heat catalyses a reaction between the first and second functional groups.

4. EMI shielding material as in claim 3, packaged as a kit comprising:

   a first container containing a first pre-mixed component including the first species, the electrically-conductive filler, and the catalyst;
   a second container containing a second pre-mixed component including the first species, the second species, and the electrically-conductive filler; and
   a third container containing the catalyst.

5. EMI shielding material as in any of claims 1 - 4, wherein the electrically-conductive filler is a silver-based filler.

6. EMI shielding material as in any of claims 1 - 5, wherein the first species comprises a siloxane polymer including vinyl functional groups, and the second species comprises a siloxane cross-linker including reactive hydrides.

7. EMI shielding material as in any of claims 1 - 6, wherein the catalyst is a platinum catalyst.

8. EMI shielding material as in any of claims 1 - 7, the material having a viscosity of from 100 to 10,000 Pa·s (100,000 to 10,000,000 centipoise).

9. EMI shielding material as in any of claims 1 - 8, the material being in the form and shape of a cured EMI shielding gasket having resistance at 25 % deflection of less than 10 m ohms, resistance at 50 % deflection of less than 5 m ohms, and shielding effectiveness of 10-120 dB at 10 MHZ to 12 GHz.

10. EMI shielding material as in any of claims 1 - 9, the material being in the form and shape of a cured EMI shielding gasket having compression set of less than 50 % after 30 minutes at 138 °C when deflected 50 % for 22 hours at 85 °C, lap shear greater than 6,90 bar (100 psi), and a shore A hardness of less than 90.

11. EMI shielding material as in any of claims 1 - 10, further comprising a cure inhibitor.

12. An EMI shielding material as in any of claims 1 - 11, further comprising polymeric microspheres.

13. A method of making an EMI shielding gasket by extruding on a substrate an EMI shielding material as in any of claims 1 to 12, wherein
    the EMI shielding material has a viscosity of from 100 to 10,000 Pa·s (100,000 to 10,000,000 centipoise); and
    the extruded material is heated at a temperature and for a period of time sufficient to cure the material, thereby forming a gasket having bulk resistivity of less than about 0.050 ohm cm.

**14.** A method as in claim 13, further comprising prior to the extruding step:

forming the polymeric thermal addition cure system by forming a mixture of a first species having a first functional group, a second species having a second functional group that is reactive with the first functional group in the presence of a catalyst and heat, a catalyst that catalyses a reaction between the first and second functional groups, and the electrically-conductive filler.

**15.** A method as in claim 13 or 14, wherein the forming step comprises:

mixing together:

a first pre-mixed component including the first species, the electrically-conductive filler, and the catalyst; and a second pre-mixed component including the first species, the second species, and the electrically-conductive filler.

**16.** A method as in any of claims 13 - 15, further comprising:

prior to mixing together the first and second components, adding additional catalyst to the first pre-mixed component.

**17.** A method as in any of claims 13 - 16, wherein the first species comprises a siloxane polymer including vinyl functional groups, the second species comprises a siloxane cross-linker including reactive hydrides, the electrically-conductive filler comprises a silver-based electrically-conductive filler, and the catalyst comprises a platinum catalyst.

**18.** A method as in any of claims 13 - 17, wherein the electrically-conductive filler is a silver-based filler.

**19.** A method as in any of claims 13 - 18, wherein the catalyst is a platinum catalyst.

**20.** A method as in any of claims 13 - 19, the material further comprising a cure inhibitor.

**21.** A method as in any of claims 13 - 20, the material further comprising polymeric microspheres.


**Patentansprüche**

**1.** EMI-Abschirmmaterial, welches aufweist:

ein aushärtbares, fließfähiges wärmehärtendes Polymersystem;
einen Katalysator, der katalytische Aktivität aufweist, die bei Vorhandensein von Wärme eine Reaktion in dem wärmehärtenden Polymersystem katalysiert, welche dazu führt, dass das System aushärtet und hart wird, einen elektrisch leitfähigen Füllstoff, der negativ die katalytische Aktivität des Katalysators durch Vergiftung des Katalysators beeinflusst, wobei der Katalysator in einer Menge vorhanden ist, die dazu ausreicht, die katalytische Aktivität beizubehalten.

**2.** EMI-Abschirmmaterial nach Anspruch 1, bei welchem das Material eine spezifische Massenleitfähigkeit von weniger als 0,050 Ohm * cm aufweist, und leicht extrudierbar ist, und so bleibt nach Aufbewahrung bei Zimmertemperatur über einen Zeitraum von bis zumindest einer Woche, jedoch nach Einwirken einer Temperatur von zumindest 85°C über einen Zeitrum von zumindest 30 Minuten im Wesentlichen in Wärme ausgehärtet wird.

**3.** EMI-Abschirmmaterial nach Anspruch 2, bei welchem das wärmehärtende Polymersystem aufweist:

einen ersten Stoff, der eine erste Funktionsgruppe aufweist;
einen zweiten Stoff, der eine zweite Funktionsgruppe aufweist, die mit der ersten Funktionsgruppe bei Vorhandensein des Katalysators und von Wärme reaktionsfähig ist; und
der Katalysator katalytische Wirkung aufweist, die bei Vorhandensein von Wärme eine Reaktion zwischen der ersten und der zweiten Funktionsgruppe katalysiert.

**4.** EMI-Abschirmmaterial nach Anspruch 3, abgepackt als ein Bausatz, wobei vorgesehen sind:

ein erster Behälter, der eine erste vorgemischte Komponente enthält, welche den ersten Stoff, den elektrisch leitfähigen Füllstoff, und den Katalysator aufweist;

ein zweiter Behälter, der eine zweite vorgemischte Komponente enthält, welche den ersten Stoff, den zweiten Stoff, und den elektrisch leitfähigen Füllstoff umfasst; und

ein dritter Behälter, welcher den Katalysator enthält.

5. EMI-Abschirmmaterial nach einem der Ansprüche 1 bis 4, bei welchem der elektrisch leitfähige Füllstoff ein Füllstoff auf Silbergrundlage ist.

6. EMI-Abschirmmaterial nach einem der Ansprüche 1 bis 5, bei welchem der erste Stoff ein Siloxanpolymer aufweist, welches Vinyl-Funktionsgruppen enthält, und der zweite Stoff ein Siloxan-Vernetzungsmittel aufweist, welches reaktive Hydride enthält.

7. EMI-Abschirmmaterial nach einem der Ansprüche 1 bis 6, bei welchem der Katalysator ein Platin-Katalysator ist.

8. EMI-Abschirmmaterial nach einem der Ansprüche 1 bis 7, welches eine Viskosität von 100 bis 10.000 Pa*s aufweist (100.000 bis 10.000.000 Centipoise).

9. EMI-Abschirmmaterial nach einem der Ansprüche 1 bis 8, welches die Gestalt und Form einer ausgehärteten EMI-Abschirmdichtung aufweist, die einen Widerstand bei 25% Auslenkung von weniger als 10 m Ohm aufweist, einen Widerstand bei 50 % Auslenkung von weniger als 5 m Ohm, und einen Abschirmwirkungsgrad von 10 bis 120 dB bei 10 MHz bis 12 GHz.

10. EMI-Abschirmmaterial nach einem der Ansprüche 1 bis 9, welches die Gestalt und Form einer ausgehärteten EMI-Abschirmdichtung aufweist, die eine bleibende Verformung von weniger als 50 % nach 30 Minuten bei 138°C aufweist, bei einer Auslenkung von 50 % über 22 Stunden bei 85°C, eine Überlappungsscherung von mehr als 6,90 Bar (100 psi), und eine Shore-A-Härte von weniger als 90.

11. EMI-Abschirmmaterial nach einem der Ansprüche 1 bis 10, welches weiterhin einen Aushärtungshemmer aufweist.

12. EMI-Abschirmmaterial nach einem der Ansprüche 1 bis 11, welches weiterhin Polymer-Mikrokugeln aufweist.

13. Verfahren zur Herstellung einer EMI-Abschirmdichtung durch Extrudieren eines EMI-Abschirmmaterials auf ein Substrat, nach einem der Ansprüche 1 bis 12, bei welchem

das EMI-Abschirmmaterial eine Viskosität von 100 bis 10.000 Pa * s aufweist (100.000 bis 10.000.000 Centipoise); und

das extrudierte Material bei einer Temperatur und über einen Zeitraum erwärmt wird, die zum Aushärten des Materials ausreichen, wodurch eine Dichtung ausgebildet wird, die eine spezifische Massenleitfähigkeit von weniger als etwa 0,050 Ohm * cm aufweist.

14. Verfahren nach Anspruch 13, bei welchem vor dem Schritt des Extrudierens vorgesehen ist:

Ausbilden des wärmehärtenden Polymersystems durch Ausbilden einer Mischung aus einem ersten Stoff, der eine erste Funktionsgruppe aufweist, einem zweiten Stoff, der eine zweite Funktionsgruppe aufweist, die mit der ersten Funktionsgruppe bei Vorhandensein eines Katalysators und von Wärme reaktionsfähig ist, einem Katalysator, der eine Reaktion zwischen der ersten und der zweiten Funktionsgruppe katalysiert, und dem elektrisch leitfähigen Füllstoff.

15. Verfahren nach Anspruch 13 oder 14, bei welchem der Ausbildungsschritt umfasst:

Zusammenmischen von:

einer ersten vorgemischten Komponente, welche den ersten Stoff, den elektrisch leitfähigen Füllstoff, und den Katalysator enthält; und

einer zweiten vorgemischten Komponente, welche den ersten Stoff, den zweiten Stoff, und den elektrisch leitfähigen Füllstoff aufweist.

16. Verfahren nach einem der Ansprüche 13 bis 15, welches weiterhin aufweist:

17

Hinzufügen zusätzlichen Katalysators zur ersten vorgemischten Komponente vor dem Zusammenmischen der ersten und zweiten Komponente.

**17.** Verfahren nach einem der Ansprüche 13 bis 16, bei welchem der erste Stoff ein Siloxanpolymer aufweist, welches Vinyl-Funktionsgruppen enthält, der zweite Stoff ein Siloxan-Vernetzungsmittel aufweist, welches reaktive Hydride enthält, der elektrisch leitfähige Füllstoff einen elektrisch leitfähigen Füllstoff auf Silbergrundlage aufweist, und der Katalysator einen Platin-Katalysator aufweist.

**18.** Verfahren nach einem der Ansprüche 13 bis 17, bei welchem der elektrisch leitfähige Füllstoff ein Füllstoff auf Silbergrundlage ist.

**19.** Verfahren nach einem der Ansprüche 13 bis 18, bei welchem der Katalysator ein Platin-Katalysator ist.

**20.** Verfahren nach einem der Ansprüche 13 bis 19, bei welchem das Material weiterhin einen Aushärtungshemmer aufweist.

**21.** Verfahren nach einem der Ansprüche 13 bis 20, bei welchem das Material weiterhin Polymer-Mikrokugeln aufweist.

**Revendications**

**1.** Matériau de protection EMI comprenant :

- un système polymère fluide durcissable par apport de chaleur,
- un catalyseur à activité catalytique qui, en présence de chaleur, catalyse dans le système polymère durcissant par apport de chaleur une réaction qui amène le système à prendre et durcir,
- une charge électriquement conductrice qui affecte négativement l'activité catalytique du catalyseur en empoisonnant le catalyseur, le catalyseur étant présent à un niveau suffisant pour maintenir ladite activité catalytique.

**2.** Matériau de protection EMI selon la revendication 1, **caractérisé en ce que** ledit matériau présente une résistivité en vrac inférieure à 0,050 ohm cm, peut facilement être extrudé et peut encore être extrudé après un stockage à température ambiante pendant au moins une semaine, et **en ce que** le matériau devient essentiellement durci thermiquement lorsqu'on l'expose à une température d'au moins 85°C pendant au moins 30 minutes.

**3.** Matériau de protection EMI selon la revendication 2, **caractérisé en ce que** le système polymère durcissant par apport de chaleur comprend :

- une première substance qui présente un premier groupe fonctionnel,
- une deuxième substance qui présente un deuxième groupe fonctionnel qui réagit avec le premier groupe fonctionnel en présence du catalyseur et de chaleur et

**en ce que** le catalyseur présente une action catalytique qui, en présence de chaleur, catalyse une réaction entre le premier groupe fonctionnel et le deuxième groupe fonctionnel.

**4.** Matériau de protection EMI selon la revendication 3, conditionné en une trousse qui comprend :

- un premier récipient qui contient un premier composant prémélangé contenant la première substance, la charge électriquement conductrice et le catalyseur,
- un deuxième récipient qui contient un deuxième composant prémélangé contenant la première substance, la deuxième substance et la charge électriquement conductrice et
- un troisième récipient qui contient le catalyseur.

**5.** Matériau de protection EMI selon l'une quelconque des revendications 1 à 4, **caractérisé en ce que** la charge électriquement conductrice est une charge à base d'argent.

**6.** Matériau de protection EMI selon l'une quelconque des revendications 1 à 5, **caractérisé en ce que** la première substance comprend un polymère de siloxane contenant des groupes fonctionnels vinyle et **en ce que** la deuxième substance comprend un agent de réticulation siloxane qui contient des hydrures réactifs.

**7.** Matériau de protection EMI selon l'une quelconque des revendications 1 à 6, **caractérisé en ce que** le catalyseur est un catalyseur au platine.

**8.** Matériau de protection EMI selon l'une quelconque des revendications 1 à 7, **caractérisé en ce que** la viscosité du matériau est comprise entre 100 et 10 000 Pa·s (entre 100 000 et 10 000 000 centipoises).

**9.** Matériau de protection EMI selon l'une quelconque des revendications 1 à 8, **caractérisé en ce que** le matériau présente la forme d'un joint de protection EMI dont la résistance est de moins de 10 m ohms à une déformation de 25 %, dont la résistance est de moins de 5 m ohms à une déformation de 50 % et dont l'efficacité de la protection est de 10 à 120 dB dans l'intervalle de 10 MHz à 12 GHz.

**10.** Matériau de protection EMI selon l'une quelconque des revendications 1 à 9, **caractérisé en ce que** le matériau présente la forme d'un joint de protection EMI dont la déformation rémanente à la compression est inférieure à 50 % après 30 minutes à 138°C lorsqu'il est déformé à 50 % pendant 22 heures à 85°C, dont la résistance au cisaillement à recouvrement est supérieure à 6,90 bar (100 psi) et dont la dureté Shore A est inférieure à 90.

**11.** Matériau de protection EMI selon l'une quelconque des revendications 1 à 10, qui comprend de plus un inhibiteur de prise.

**12.** Matériau de protection EMI selon l'une quelconque des revendications 1 à 11, qui comprend de plus des microsphères en polymère.

**13.** Procédé de fabrication d'un joint de protection EMI en extrudant sur un substrat un matériau de protection EMI selon l'une quelconque des revendications 1 à 12, **caractérisé en ce que** :

- la viscosité du matériau de protection EMI est comprise entre 100 et 10 000 Pa·s (entre 100 000 et 10 000 000 centipoises) et
- le matériau extrudé est chauffé à une température et pendant une durée suffisantes pour durcir le matériau, ce qui permet de former un joint dont la résistivité en vrac est d'au moins environ 0,050 ohm cm.

**14.** Procédé selon la revendication 13, comprenant de plus avant l'étape d'extrusion :

- l'étape qui consiste à former le système polymère durcissant par apport de chaleur en formant un mélange constitué d'une première substance qui présente un premier groupe fonctionnel, d'une deuxième substance qui présente un deuxième groupe fonctionnel qui réagit avec le premier groupe fonctionnel en présence d'un catalyseur et de chaleur, d'un catalyseur qui catalyse une réaction entre le premier groupe fonctionnel et le deuxième groupe fonctionnel et d'une charge électriquement conductrice.

**15.** Procédé selon les revendications 13 ou 14, **caractérisé en ce que** l'étape de formation comprend l'étape qui consiste à mélanger :

- un premier composant prémélangé contenant la première substance, la charge électriquement conductrice et le catalyseur et
- un deuxième composant prémélangé contenant la première substance, la deuxième substance et la charge électriquement conductrice.

**16.** Procédé selon l'une quelconque des revendications 13 à 15, comprenant de plus l'étape qui consiste à ajouter un supplément de catalyseur au premier composant prémélangé avant de mélanger le premier composant et le deuxième composant.

**17.** Procédé selon l'une quelconque des revendications 13 à 16, **caractérisé en ce que** la première substance comprend un polymère de siloxane contenant des groupes fonctionnels vinyle, la deuxième substance contient un agent de réticulation siloxane comprenant des hydrures réactifs, la charge électriquement conductrice contient une charge électriquement conductrice à base d'argent et le catalyseur contient un catalyseur au platine.

**18.** Procédé selon l'une quelconque des revendications 13 à 17, **caractérisé en ce que** la charge électriquement conductrice est une charge à base d'argent.

**19.** Procédé selon l'une quelconque des revendications 13 à 18, **caractérisé en ce que** le catalyseur est un catalyseur au platine.

**20.** Procédé selon l'une quelconque des revendications 13 à 19, **caractérisé en ce que** le matériau contient de plus un inhibiteur de prise.

**21.** Procédé selon l'une quelconque des revendications 13 à 20, **caractérisé en ce que** le matériau contient de plus des microsphères en polymère.

Fig. 1

Fig. 2

Fig. 3

Fig. 4

Fig. 5

Fig. 6

Fig. 7

Fig. 8

Fig. 9
(Prior Art)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5366664 A
- US 4931479 A
- US 4643924 A
- EP 0326704 A
- US 5115104 A